# FASCICULE DE BREVET EUROPEEN

(11) **EP 2 613 343 B1**
(45) Date de publication et mention de la délivrance du brevet: **28.08.2019**
(21) Numéro de dépôt: 13150310.4
(22) Date de dépôt: 04.01.2013
(51) Int. Cl.: H01L 21/28, H01L 29/423, H01L 29/66, H01L 29/792, H01L 27/115

(54) **Procédé de fabrication d'une cellule mémoire non volatile à double grille**
Verfahren zur Herstellung einer nichtflüchtigen Speicherzelle mit Doppel-Gate
Method for manufacturing a double-gate non-volatile memory cell

(30) Priorité: 09.01.2012 FR 1250205
(43) Date de publication de la demande: 10.07.2013
(73) Titulaire: COMMISSARIAT À L'ÉNERGIE ATOMIQUE ET AUX ÉNERGIES ALTERNATIVES, 75015 Paris (FR)
(72) Inventeur: Charpin-Nicolle, Christelle, 38120 FONTANIL-CORNILLON (FR)
(74) Mandataire: Hautier, Nicolas

(56) Documents cités:
- EP-A1- 2 381 471
- JP-A- 2011 187 562
- US-A1- 2007 228 498
- US-A1- 2010 078 706

## Description

### DOMAINE TECHNIQUE DE L'INVENTION

L'invention concerne le domaine des dispositifs mémoires ou mémoires électroniques de type non-volatiles. Elle trouve pour application particulièrement avantageuse le domaine des mémoires électroniques de type Flash à double grille comprenant une grille de commande également désignée grille du transistor de commande et une grille de mémorisation également désignée grille de contrôle du transistor de mémorisation.

### ÉTAT DE LA TECHNIQUE

Il existe plusieurs types de mémoires non-volatiles, c'est-à-dire des mémoires conservant une information stockée en l'absence d'alimentation électrique, et pouvant être écrites et/ou effacées électriquement :
- les EPROMs, de l'anglais « Erasable Programmable Read Only Memories » c'est-à-dire « mémoires mortes (à lecture seule) effaçables et programmables » dont le contenu peut être écrit électriquement, mais qui doivent être soumises à un rayonnement ultra violet (UV) pour effacer les informations qui y sont mémorisées.
- les EEPROMs, de l'anglais « Electrically Erasable Programmable ROMs » c'est-à-dire « mémoires mortes effaçables et programmables électriquement » dont le contenu peut donc être écrit et effacé électriquement, mais qui requièrent pour leur réalisation des surfaces de semi-conducteur plus importantes que les mémoires de type EPROM, et qui sont donc plus coûteuses à réaliser.
- les mémoires Flash. Ces mémoires non volatiles ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en terme de densité d'intégration et l'avantage des mémoires EEPROMs en terme d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, notamment les clés dites USB, de l'anglais « universal serial bus » qui sont capables de se connecter directement sur un « bus série universel » devenu un standard de la micro informatique, et bien d'autres applications. Les mémoires Flash ne possèdent pas d'éléments mécaniques, ce qui leur confère de plus une assez grande résistance aux chocs.

La plupart des mémoires Flash sont du type « stand-alone » c'est-à-dire qu'il s'agit de dispositifs autonomes présentant de grandes capacités de stockage, généralement supérieures à 1 gigabit ou Gb (1Gb = 10⁹ bits), et qui sont dédiées aux applications de stockage de masse.

Il existe également des mémoires Flash dites embarquées dont la réalisation est intégrée à celle d'un procédé, par exemple celui dit CMOS, acronyme de l'anglais « complementary metal oxide semiconductor », procédé technologique le plus largement utilisé par l'industrie de la microélectronique pour la réalisation de circuits intégrés à base de transistors « complémentaires » (C) de type « métal-oxyde-semiconducteur » (MOS). Ces mémoires trouvent un intérêt croissant, par exemple dans les domaines de l'automobile ou des microcontrôleurs, pour le stockage de données ou de codes. Ces mémoires Flash embarquées sont réalisées sur une puce qui comporte également des circuits CMOS destinés à réaliser des fonctions logiques autres qu'une mémorisation de données. Ces mémoires Flash embarquées sont généralement réalisées pour des capacités de stockage plus faibles que celles des mémoires de type « stand-alone », leur capacité pouvant varier généralement de quelques bits à quelques mégabits ou Mb (1 Mb = 10⁶ bits). Les caractéristiques visées des mémoires Flash embarquées sont un faible coût de réalisation, une excellente fiabilité (notamment à haute température), une faible consommation électrique, ou encore une vitesse de programmation élevée, ces caractéristiques étant fonction de l'application à laquelle elles sont destinées.

La plupart des points mémoires Flash ont une structure de type transistor MOS comprenant trois électrodes : source, drain et grille, cette dernière permettant de créer un canal de conduction entre source et drain. Leur particularité pour permettre la mémorisation non volatile d'une information est qu'elles comportent en outre un site de stockage de charges électriques, appelé grille flottante, formé par exemple d'une couche de silicium polycristallin disposée entre deux couches d'oxyde, placés entre le matériau électriquement conducteur de grille et le canal du transistor. La mémorisation est obtenue en appliquant sur le matériau conducteur une tension supérieure à la tension de seuil, par exemple comprise entre 15 volts et 20 volts, de façon à stocker l'information sous la forme de charges piégées par la grille flottante.

Cependant, de telles mémoires présentent des inconvénients limitant la réduction de leurs dimensions. En effet, une réduction de l'épaisseur de l'oxyde tunnel qui est disposé entre le canal et la couche de silicium polycristallin constituant la grille flottante, entraîne une augmentation du SILC, acronyme de l'anglais « stress induced leakage current » désignant le « courant de fuite induit par la tension ». L'utilisation prolongée d'une telle mémoire, c'est-à-dire la répétition de cycles d'écriture et d'effacement, génère à la longue des défauts dans l'oxyde tunnel qui tendent à évacuer les charges piégées dans la grille flottante. De même un SILC ou courant de fuite important affecte le temps de rétention des charges dans la grille flottante. Dans la pratique, il est donc difficile de réduire l'épaisseur de l'oxyde tunnel de ces mémoires à moins de 8 nanomètres ou nm (1nm = 10⁻⁹ mètre) sans que le SILC ne devienne un phénomène critique pour la mémorisation. De plus, en réduisant les dimensions d'une telle cellule mémoire, le couplage parasite entre les grilles flottantes de deux cellules adjacentes d'une même mémoire devient important et peut donc dégrader la fiabilité de la mémoire.

Pour ces raisons, des mémoires de type MONOS (Métal Oxyde Nitrure Oxyde Silicium), également appelées mémoires NROM, ont été proposées pour remplacer les mémoires à grille flottante en silicium polycristallin. Le document US 5 768 192 décrit de telles mémoires dans lesquelles les charges électriques sont stockées dans des pièges formés dans une grille flottante composée de nitrure et disposée entre deux couches d'oxyde. Dans une telle couche de nitrure, les pièges sont isolés les uns des autres. Ainsi, un électron stocké dans un des pièges reste localisé physiquement dans ce piège, ce qui rend ces mémoires beaucoup moins sensibles aux défauts dans l'oxyde tunnel, et donc moins impactées par une augmentation du SILC. En effet, en présence d'un défaut dans l'oxyde tunnel, la couche de mémorisation, c'est-à-dire la couche de nitrure, perd uniquement les électrons situés au voisinage du défaut, les autres électrons piégés n'étant pas affectés par ce défaut. Ces mémoires disposent donc d'une meilleure fiabilité. Il est ainsi possible d'avoir un oxyde tunnel d'épaisseur inférieure à environ 8 nm, et donc de réduire les tensions de programmation nécessaires. De plus, du fait de la faible épaisseur du nitrure pour former la couche de mémorisation, le couplage entre deux cellules mémoires adjacentes est fortement réduit par rapport à des cellules à grille flottante en silicium polycristallin. Enfin, la structure d'une mémoire de type NROM est également adaptée pour réaliser des mémoires embarquées en raison de la simplicité du procédé d'intégration de ces mémoires.

Le document de S. Kianian et coauteurs « A novel 3 volt-only, small sector erase, high density flash E2PROM", Technical Digest of VLSI Technology, 1994, p.71 », décrit un autre type de mémoire, appelée mémoire « split-gate », c'est-à-dire mémoire à « grille partagée » qui combine au sein d'une même cellule mémoire un transistor de mémorisation et un transistor de sélection (ou transistor de commande) formés sur une unique zone active. Une telle cellule mémoire à double grille est généralement programmée par injection de porteurs par la source, mécanisme qui requiert la présence d'un transistor de sélection accolé au transistor de mémorisation, et qui permet d'augmenter la vitesse de programmation tout en réduisant la consommation par rapport à une mémoire de type NROM.

Afin de bénéficier des avantages de chacune des structures ci-dessus, c'est-à-dire : split-gate et NROM, le document US 2004/207025 propose un autre type de mémoire à double grille combinant les deux structures. Une des difficultés pour réaliser ces mémoires concerne alors le contrôle de la position relative des grilles, la grille du transistor de commande et la grille de contrôle du transistor de mémorisation, l'une par rapport à l'autre. En effet, ces grilles sont réalisées par deux photolithographies successives, le désalignement de la seconde grille par rapport à la première grille fixant la longueur de la seconde grille. Un mauvais contrôle des positions relatives des deux grilles se traduit donc par un mauvais contrôle des caractéristiques électriques du second transistor et de ses performances électriques, et donc potentiellement de mauvaises performances électriques de la mémoire. Par conséquent, un contrôle très précis de la position des grilles est nécessaire lors de la réalisation de ce type de mémoire.

Afin de s'affranchir de cette contrainte d'alignement, le document US 7 130 223 propose également de réaliser une mémoire à double grille combinant la structure d'une mémoire de type NROM avec une architecture split-gate. Cependant, la grille de contrôle du transistor de mémorisation, c'est-à-dire la grille comportant la couche de mémorisation de données, est dans ce cas réalisée sous la forme d'un espaceur latéral de la grille du transistor de commande, lequel est disposé contre un des deux flancs latéraux de la grille du transistor de commande. Une telle structure permet de contrôler précisément la position et la dimension de la grille de contrôle du transistor de mémorisation par rapport à la grille du transistor de commande. En effet, la grille de contrôle du transistor de mémorisation étant réalisée sous la forme d'un espaceur latéral de la grille du transistor de commande celle-ci se trouve être alors auto alignée sur cette dernière.

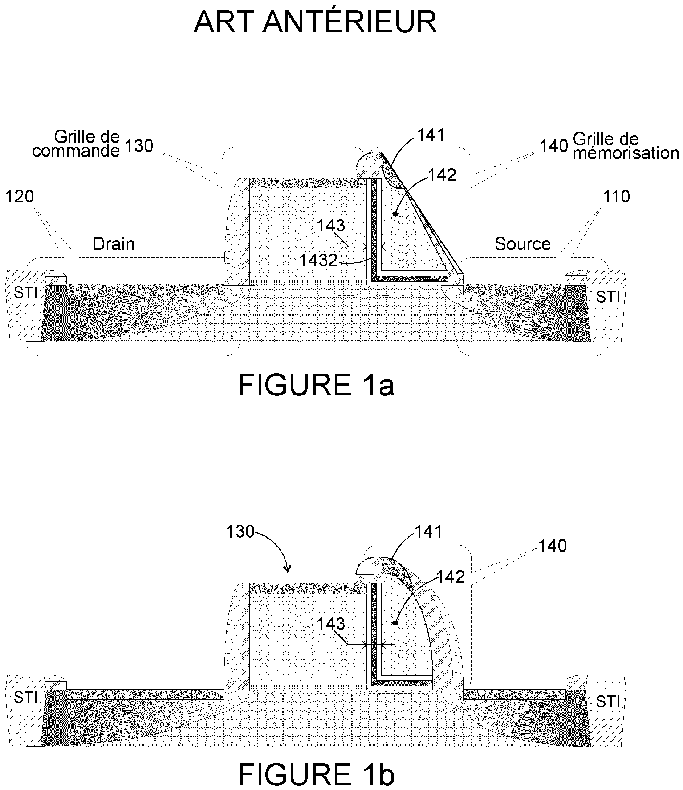

Toutefois, avec une telle structure, il est très difficile de réaliser ensuite une reprise de contact électrique sur la grille de contrôle du transistor de mémorisation compte tenu des faibles dimensions de cette grille en forme d'espaceur latéral. Ce problème est illustré sur la figure 1. La figure 1a montre une vue en coupe d'un exemple d'une telle cellule mémoire à double grille. Entre les zones source 110 et drain 120 on dispose les deux grilles partagées par une même cellule. Comme mentionné ci-dessus, la grille de contrôle 140 du transistor de mémorisation, également désignée grille de mémorisation 140, est réalisée, côté source 110, sous la forme d'un espaceur de la grille 130 du transistor de commande et est de ce fait auto alignée sur celle-ci. La grille 130 du transistor de commande, également désignée grille de commande 130, qui est comparable à celle d'un simple transistor de type MOS, peut être réalisée d'une façon traditionnelle par divers moyens et procédés connus de l'homme du métier. Sur la figure 1a on voit que la surface 141, qui permet d'établir un contact électrique avec la grille de contrôle 140 du transistor de mémorisation, est particulièrement limitée dans le cas d'un espaceur de forme triangulaire. Forme qui résulte le plus naturellement de la formation de l'espaceur avec les moyens et procédés connus de l'homme du métier de façon à ce que l'ensemble des couches constituant la grille de contrôle du transistor de mémorisation soit auto alignée sur la grille 130 du transistor de commande. La surface de contact 141 correspond à la siliciuration du matériau sous-jacent qui est du silicium polycristallin 142 et qui constitue, en volume, l'essentiel de la grille de contrôle du transistor de mémorisation. La mémorisation est typiquement obtenue à l'aide d'un empilement ou sandwich de couches 143 contenant une couche de piégeage de charges électriques. Cette couche de piégeage constitue la grille flottante qui sert à piéger les charges mémorisant l'état de la cellule mémoire dans la grille de contrôle du transistor de mémorisation comme décrit précédemment.

La figure 1b montre une vue en coupe d'un autre exemple d'une telle cellule mémoire à double grille où la surface de contact 141 de la grille de contrôle du transistor de mémorisation est agrandie en s'efforçant d'obtenir la forme la plus arrondie possible de l'espaceur. Ce type de forme est toutefois difficile à obtenir en utilisant les procédés de microélectronique, notamment avec du silicium polycristallin 142, matériau qui constitue l'essentiel de la grille de contrôle du transistor de mémorisation.

La reprise de contact sur la grille de contrôle du transistor de mémorisation est très délicate à mettre en oeuvre dans le cadre d'un processus industriel et demande notamment des spécifications de positionnement très contraignantes pour que les vias de connexions, en particulier ceux de connexion de la grille de contrôle du transistor de mémorisation, soient toujours bien positionnés. Un défaut de positionnement des vias empêcherait le fonctionnement de la cellule et pourrait en particulier créer un court circuit entre grille du transistor de commande et grille de contrôle du transistor de mémorisation.

Les documents JP 2011 187562, US2007/228498, US2010078706 et EP2381471 décrivent d'autres solutions présentant certains au moins des inconvénients mentionnés précédemment.

Un objet de la présente invention est donc de proposer une nouvelle
structure de cellule mémoire ou un nouveau procédé permettant de faciliter la reprise de contact de chacune des grilles et de limiter les risques de court-circuit.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de fabrication d'une cellule mémoire non volatile à double grille comprenant un transistor de commande comprenant une grille et un transistor de mémorisation comprenant une grille de contrôle adjacente à la grille du transistor de commande, dans lequel on effectue les étapes suivantes: formation au moins partielle de la grille du transistor de commande comprenant notamment l'obtention d'un relief en un matériau de préférence semi conducteur sur un substrat ; formation de la grille de contrôle du transistor de mémorisation, comprenant de préférence une étape de dépôt d'une couche en un matériau de préférence semi conducteur de manière à recouvrir le relief de la grille du transistor de commande au moins.

La formation de la grille de contrôle du transistor de mémorisation comprend en outre les étapes suivantes de:
∘ dépôt sur la couche en un matériau semi conducteur d'une autre couche. L'épaisseur de cette autre couche est de préférence telle que la face supérieure de ladite autre couche est en tout point située au dessus du relief de la grille du transistor de commande ;
∘ polissage mécano chimique CMP effectué de manière à retirer, au dessus du relief de la grille du transistor de commande, ladite autre couche et une partie de la couche en un matériau semi conducteur ;
∘ retrait de ladite autre couche restante de part et d'autre du relief de la grille du transistor de commande,
∘ gravure de la couche en un matériau semi conducteur de sorte à retirer ce matériau au dessus du relief de la grille du transistor de commande et à ne le laisser subsister qu'un motif sur au moins un flanc du relief de la grille du transistor de commande.

Ainsi, le fond des dénivellations de ladite autre couche est à un niveau égal ou supérieur aux hauts des dénivellations de la couche en un matériau semi conducteur. Ladite autre couche permet donc, lors de l'étape de polissage mécano chimique, de retirer une partie substantielle de la couche en silicium polycristallin située au dessus du motif sans pour autant retirer cette couche sur les flancs du relief de la grille du transistor de commande. La largeur du motif formant un espaceur est donc augmentée.

La surface de contact de la grille de contrôle du transistor de mémorisation formée à partir de ce motif est donc significativement étendue. Le positionnement de la grille de contact par rapport à un via de connexion avec les couches de câblage supérieures est ainsi facilité.

Par ailleurs, le volume de matériau accessible et disponible par la suite pour effectuer une siliciuration est également augmenté ce qui permet d'améliorer la connexion électrique entre la grille du transistor de commande et les couches de câblage.

De manière facultative, l'invention peut en outre présenter au moins l'une quelconque des caractéristiques optionnelles suivantes :
- Avantageusement, l'étape de polissage mécano chimique comprend une première étape de polissage mécano chimique effectuée de manière à rendre plan la surface de ladite autre couche ou la conserver le plus plane possible.
- De manière encore plus avantageuse, l'étape de polissage mécano chimique comprend une deuxième étape de polissage mécano chimique effectuée de manière à réduire l'épaisseur de la couche en un matériau semi conducteur située au dessus du relief de la grille du transistor de commande.
- Avantageusement, l'étape de polissage mécano chimique est effectuée de sorte à retirer au moins 20 % de l'épaisseur de couche en un matériau semi conducteur. De préférence, l'étape de polissage mécano chimique est effectuée de sorte à retirer au moins 40 % de l'épaisseur de couche en un matériau semi conducteur. De préférence, au cours de cette étape on retire entre 40% et 60% de l'épaisseur de couche en un matériau semi conducteur.
- De préférence, l'étape de gravure comprend notamment une gravure anisotrope de la couche en un matériau semi conducteur. Cette gravure anisotrope est dirigée perpendiculairement au plan du substrat, soit verticalement et vers le bas sur les figures de l'exemple illustré.
- De préférence, l'étape de gravure anisotrope est effectuée de sorte à préserver, au dessus du relief de la grille du transistor de commande, une épaisseur de la couche en un matériau semi conducteur supérieure à 5 nm et de préférence comprise entre 5 et 10 nm.
- De préférence, l'étape de gravure comprend, après la gravure anisotrope, une gravure isotrope de la couche en un matériau semi conducteur restant avec arrêt de la gravure sur une couche supérieure d'oxyde et dans lequel la couche supérieure d'oxyde est disposée sur le relief de la grille du transistor de commande préalablement au dépôt sur la couche en un matériau semi conducteur.
- Avantageusement, l'étape de dépôt de la couche en un matériau semi conducteur est effectuée de sorte que son épaisseur est comprise entre 0,2 et 0,8 fois l'épaisseur du relief formant partiellement la grille du transistor de commande. De manière encore plus avantageuse, l'épaisseur de la couche en un matériau semi conducteur est comprise entre 0,3 et 0,6 fois l'épaisseur du relief formant partiellement la grille du transistor de commande. De manière encore plus avantageuse, l'épaisseur de la couche en un matériau semi conducteur est sensiblement égale à la moitié de l'épaisseur de silicium du relief formant partiellement la grille du transistor de commande. Cette épaisseur permet d'avoir une marche nette entre le dessus du relief surmonté de la couche en un matériau semi conducteur et cette même couche en dehors du relief. En tout état de cause, l'épaisseur de la couche en matériau semi conducteur telle que déposée est inférieure à la hauteur de la grille du transistor de commande. Ainsi, en dehors de la grille du transistor de commande, la face supérieure de la couche en matériau semi conducteur est située en dessous du sommet de la grille du transistor de commande.
- Avantageusement, l'épaisseur de la couche en un matériau semi conducteur est inférieure à l'épaisseur de ladite autre couche.
- De préférence, l'étape de dépôt de la couche en un matériau semi conducteur est conforme, l'épaisseur de la couche en un matériau semi conducteur étant sensiblement constante même en présence de motifs.
- De préférence, l'étape de dépôt de ladite autre couche est effectuée de sorte que son épaisseur est supérieure à l'épaisseur du relief formant partiellement la grille du transistor de commande. De préférence, l'épaisseur de ladite autre couche est supérieure à 1.1 et encore plus préférentiellement 1.3 fois l'épaisseur du relief formant partiellement la grille du transistor de commande. De manière avantageuse, l'épaisseur de ladite autre couche est supérieure à l'épaisseur du relief formé par le relief et l'empilement de couches comprenant la couche de piégeage.
- Avantageusement, le relief de la grille du transistor de commande est en silicium. De préférence le relief de la grille du transistor de commande est en silicium polycristallin.
- Avantageusement, la couche en un matériau semi conducteur est en silicium polycristallin.
- Avantageusement, ladite autre couche est en SiO₂.
- Avantageusement, la grille de contrôle du transistor de mémorisation forme un espaceur pour la grille du transistor de commande.
- Avantageusement, la formation de la grille de contrôle du transistor de mémorisation est effectuée de sorte que la grille de contrôle du transistor de mémorisation est auto alignée avec la grille du transistor de commande.
- De préférence, préalablement à l'étape de dépôt de la couche en un matériau semi conducteur, une étape de formation sur au moins un flanc du relief de la grille du transistor de commande et au moins une partie du substrat, d'un empilement de couches configuré pour stocker des charges électriques, l'empilement de couches comprenant deux couches d'isolant électrique, enserrant une couche intermédiaire de piégeage de charges.
- De préférence, le procédé comprend une étape de siliciuration d'une surface supérieure du motif.

Un autre aspect de l'invention concerne une cellule mémoire obtenue selon le procédé selon l'une quelconque des revendications précédentes.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a et 1b illustrent des cellules mémoires à double grille de l'art antérieur.
La FIGURE 2, qui comprend les figures 2a à 2h, décrit des étapes du procédé selon l'invention et qui permettent d'obtenir une reprise de contact beaucoup plus large sur la grille de contrôle du transistor de mémorisation d'une cellule mémoire à double grille.
La FIGURE 3, qui comprend les figures 3a à 3f, illustre des étapes additionnelles qui complètent la formation de la grille de contrôle du transistor de mémorisation d'une cellule mémoire à double grille.
La FIGURE 4, illustre une cellule mémoire à double grille selon un mode particulier de réalisation qui peut être optionnellement être obtenu en mettant en oeuvre le procédé selon l'invention.

Les dessins joints sont donnés à titre d'exemples et ne sont pas limitatifs de l'invention.

### DESCRIPTION DÉTAILLÉE DE L'INVENTION

Il est rappelé que l'un des objectifs de l'invention est d'obtenir une zone de reprise de contact plus large qui permet de positionner plus facilement sur la grille de contrôle du transistor de mémorisation un via de connexion avec les couches de câblage supérieures.

Il est précisé que dans le cadre de la présente demande de brevet, le terme « sur » ne signifie pas obligatoirement « au contact de ». Ainsi par exemple, le dépôt d'une couche de poly silicium sur une couche d'isolant, ne signifie pas obligatoirement que la couche de poly silicium est directement au contact de la couche d'isolant mais cela signifie qu'elle la recouvre au moins partiellement en étant soit directement à son contact soit en étant séparé d'elle par une autre couche ou un autre élément.

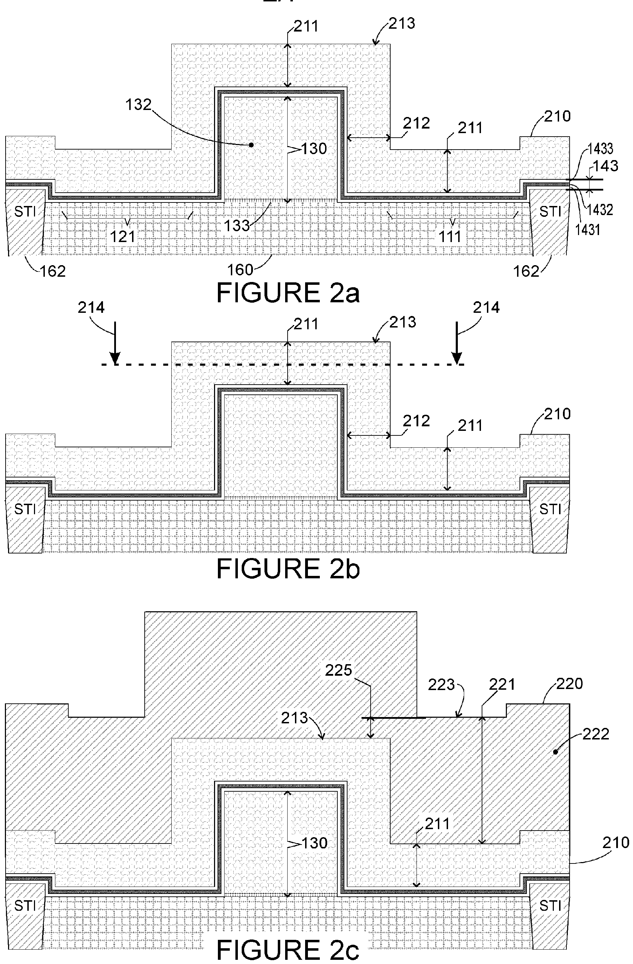

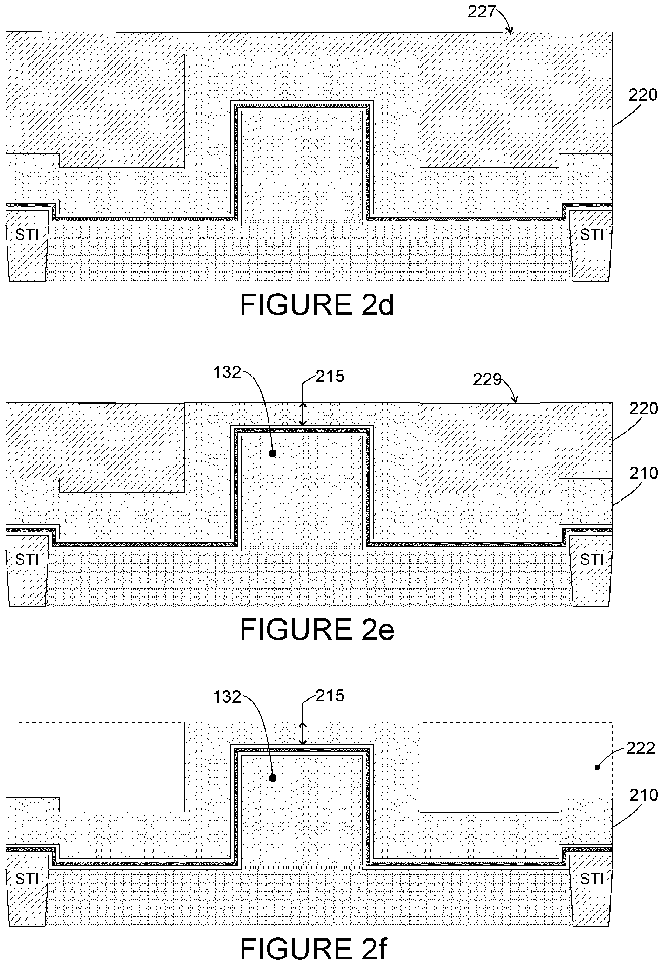

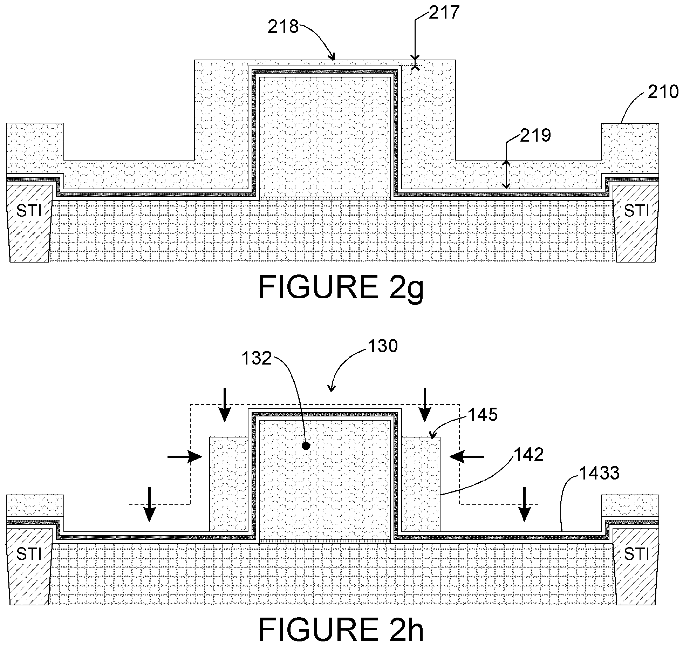

La **figure 2****,** qui comprend les figures 2a à 2e, illustre les étapes d'un exemple de procédé selon l'invention qui permet d'obtenir une surface de contact plus importante sur le transistor de mémorisation et plus précisément sur la grille de contrôle du transistor de mémorisation.

La **figure 2a** est une vue en coupe, similaire à celle de la figure 1a, d'une cellule mémoire à double grille à un stade du procédé de fabrication où l'on a déjà formé en partie au moins le transistor de commande et où l'on s'apprête à réaliser le transistor de mémorisation auto alignée, sans avoir recours à des opérations de lithographie. On rappelle que le transistor de commande et le transistor de mémorisation partagent la même source et le même drain. Ils sont donc compris dans une même cellule. Cette cellule est qualifiée habituellement de transistor double grille, chacune des grilles permettant d'assurer la fonction du transistor, soit de commande soit de mémorisation, auquel elle est dédiée. Jusqu'à ce stade, la fabrication d'une telle cellule mémoire se fait en utilisant les méthodes et moyens conventionnels mis en oeuvre par l'industrie de la microélectronique notamment ceux pour la fabrication des transistors de type MOS. D'une façon standard, ces transistors, comme les cellules mémoires à double grille de l'invention, sont fabriqués chacun dans un caisson 160 de silicium monocristallin. Les caissons sont électriquement isolés les uns des autre par des tranchées 162 typiquement en oxyde de silicium. La formation de ces tranchées fait appel à une technique dite STI, de l'anglais « shallow trench isolation », c'est-à-dire « isolation par tranchées peu profondes ». Les caissons 160 de silicium monocristallin sont en effet le plus souvent formés à partir de la mince couche superficielle de silicium monocristallin d'un substrat élaboré de type SOI, de l'anglais « silicon on insulator », c'est-à-dire un substrat « silicium sur isolant ». Cette couche de silicium monocristallin est elle-même placée au dessus d'une « couche d'oxyde enterrée » le plus souvent désignée par son acronyme BOX de l'anglais « buried oxide layer ». Chaque caisson se trouve être ainsi complètement isolé électriquement de ses voisins, latéralement et au fond, par de l'oxyde. N'étant pas nécessaire à la compréhension du procédé de l'invention, on notera que seule la couche superficielle et les tranchées latérales 162 dans laquelle les caissons 160 sont formés sont représentés. Par ailleurs, l'utilisation d'un substrat SOI est seulement un exemple particulier de mise en oeuvre. D'autres moyens et méthodes peuvent être utilisés pour qu'une cellule mémoire à double grille, employant le procédé décrit ci-après, puisse être réalisée dans un caisson isolé 160 et qui serait obtenu autrement qu'à partir d'un substrat SOI.

La grille 130 du transistor de commande dont la géométrie a été définie par photolithographie comprend à ce stade plusieurs couches, essentiellement deux couches qui sont : la grille proprement formée par un relief 132 en matériau semi conducteur, de préférence en silicium polycristallin, et la couche d'oxyde 133 de la structure MOS sous laquelle, en fonction de la tension appliquée sur la grille du transistor de commande, on va créer un canal de conduction (non représenté) à la surface du caisson 160 entre les zones source 111 et drain 121, lesquels ne sont pas encore formés à ce stade. Source 111 et drain 121 seront obtenus généralement par implantation ionique d'un dopant de la couche de silicium monocristallin du caisson 160 d'isolement. La grille 130 du transistor de commande servant de masque, source et drain seront auto alignés sur celle-ci comme on le verra plus loin. Une première implantation ionique (non représentée) pourra être effectuée à ce stade afin de régler le seuil de conduction (VT) de la grille de contrôle du transistor de mémorisation.

La figure 2a montre les couches qui sont déposées sur l'ensemble des dispositifs en cours de fabrication en vue de réaliser la grille de contrôle du transistor de mémorisation, c'est-à-dire à la surface d'une tranche d'un semi conducteur formant substrat. Après formation des grilles de commande 130, on dépose successivement les couches formant l'empilement ou sandwich de couches 143 contenant la couche de piégeage. Un exemple non limitatif de couche de piégeage est une couche désignée par son acronyme ONO, c'est-à-dire « oxyde nitrure oxyde » de silicium. La couche intérieure 1432 de nitrure de silicium (Si₃N₄) constitue la grille flottante qui sert à piéger les charges mémorisant l'état de la cellule mémoire dans la grille de contrôle du transistor de mémorisation comme décrit précédemment. D'autres structures sont possibles. Le sandwich comporte dans cet exemple trois couches : une première couche, désignée couche inférieure 1431, formant un isolant électrique, le plus souvent de l'oxyde de silicium ou SiO₂ ; une deuxième couche, désignée couche intermédiaire ou couche de piégeage 1432, servant à piéger les charges destinées à mémoriser l'état de la cellule mémoire, il s'agit typiquement de nitrure de silicium ou Si₃N₄ ; une troisième couche, désignée couche supérieure 1433, formant également un isolant électrique, réalisée par exemple en oxyde de silicium comme pour la première couche.

Ensuite on dépose une première couche 210. Cette première couche est de préférence une couche de silicium polycristallin 210. Cette couche 210 est destinée à contribuer à la formation de la grille de contrôle du transistor de mémorisation. De préférence, la grille du transistor de commande est, comme on l'a vu ci-dessus, constituée aussi de silicium polycristallin qui a été déposé et gravé précédemment d'une façon conventionnelle.

Le dépôt sera idéalement le plus « conforme » possible. Un dépôt est dit conforme quand les épaisseurs déposées sont les mêmes, indépendamment de l'angle d'inclinaison des surfaces sur lesquelles il est effectué. L'épaisseur de la couche 210 est donc sensiblement homogène en tout point de la surface recouverte, l'épaisseur étant mesurée selon une direction perpendiculaire à la surface sur laquelle s'effectue le dépôt. Un tel résultat peut être obtenu par exemple avec une méthode de dépôt entrant dans la catégorie de celles dites par LPCVD, acronyme de l'anglais « low pressure chemical vapor déposition », c'est-à-dire « déposition chimique en phase vapeur à faible pression ». On peut alors obtenir, comme représenté sur la figure 2a, une épaisseur verticale 211 de dépôt sensiblement égale à l'épaisseur horizontale 212.

Comme montré sur la **figure 2b****,** pour pouvoir réaliser la grille de contrôle du transistor de mémorisation à partir du silicium polycristallin provenant de la couche 210 qui vient d'être déposée, l'invention prévoit qu'il faut d'abord pouvoir pratiquer un « polissage mécano chimique » de la tranche en cours de fabrication. Souvent désigné par l'acronyme CMP, de l'anglais « chemical mechanical polishing », ce polissage doit n'affecter que la partie du dépôt de la couche 210 correspondant à la surface 213, c'est-à-dire à l'empilement de couches situées au-dessus des grilles de commande 130 d'une tranche. Comme illustré sur la figure 2b ce polissage mécano chimique 214 à pour but de réduire sélectivement l'épaisseur initiale 211 de la couche 210 au dessus des grilles de commande des cellules mémoires.

Dans le cadre de la présente invention, il s'est avéré qu'en pratique ce polissage mécano chimique ne peut cependant se faire sans inconvénient directement sur la couche 210 notamment parce qu'il faut, comme on va le voir plus loin, pouvoir contrôler précisément l'arrêt du polissage mécano chimique sans affecter les grilles de commandes. Comme montré sur la **figure 2c****,** le procédé de l'invention prévoit qu'une autre couche 220 est alors déposée sur la couche 210 faite de préférence de silicium polycristallin, avant l'opération de CMP. Cette autre couche 220, également désignée couche de comblement, est par exemple constituée d'oxyde de silicium 222 (SiO₂) qui est attaquable avec un procédé de CMP approprié et peut s'enlever facilement en gravure humide sélectivement par rapport au silicium polycristallin. Pour pouvoir réaliser l'opération de CMP dans de bonnes conditions, l'épaisseur 221 de la couche 220 d'oxyde de silicium doit être telle que le fond 223 des dénivellations de cette couche doit se situer au dessus de la surface 213 correspondant à l'empilement de couches au dessus des grilles de commande 130 avant dépôt de la couche 220. En d'autres termes, il faut que la distance 225 soit supérieure à zéro. À titre d'exemple non limitatif, l'épaisseur 211 de la couche 210 de silicium polycristallin est de 65 nm et l'épaisseur 221 de la couche 220 d'oxyde de silicium est de 100 nm de façon à être dans la configuration illustrée sur la figure 2c, c'est-à-dire avec une distance 225 supérieure à zéro.

Le SiO₂ peut être déposé de différentes façons, par exemple avec une méthode de dépôt de type LPCVD déjà mentionnée ci-dessus qui permet d'obtenir une bonne conformité du matériau, c'est-à-dire une épaisseur sensiblement constante en présence ou non de motifs. Cependant, l'aspect conformité n'étant pas primordial pour ce dépôt les autres méthodes couramment pratiquées par l'industrie de la microélectronique pour le dépôt de SiO₂ peuvent aussi être employées.

On notera ici que le matériau constituant la couche 220 est un matériau dit « sacrificiel » puisqu'en effet, il est juste destiné à assurer un meilleur arrêt de la CMP et qu'il est ensuite éliminé. Le matériau constituant la couche 210 est celui de la grille mémoire. Le Sio2 est traditionnellement utilisé pour sa facilité de mise en oeuvre.

Dans ces conditions on va pouvoir procéder à un premier polissage mécano chimique dont le résultat est illustré sur la **figure 2d****.** Ce premier polissage permet de s'arrêter sur une surface plane 227 dans la couche 220 d'oxyde de silicium. L'arrêt du polissage se fait « au temps » connaissant la vitesse d'attaque de l'opération de polissage.

La **figure 2e** qui suit illustre le résultat d'une deuxième étape de polissage mécano chimique plus lente que l'on arrête cette fois sur une surface plane 229 traversant la couche 210 de silicium polycristallin jusqu'à laisser au dessus des grilles de commande une épaisseur résiduelle 215 de la couche 210 de silicium polycristallin de l'ordre de la moitié de l'épaisseur initiale 211 atteignant ainsi l'objectif illustré dans la figure 2b. L'arrêt de cette deuxième étape de polissage se fait à détection de la couche de silicium sous jacente.

La **figure 2f** montre le résultat de l'étape suivante du procédé après que l'on a procédé au retrait de l'oxyde de silicium 222 qui constituait le matériau de la couche 220 qui a permis le polissage mécano chimique des parties de la couche 210 de silicium polycristallin situées au dessus des grilles de commande 130. L'enlèvement de l'oxyde de silicium se fait en employant de l'acide fluorhydrique (HF) dilué qui est très sélectif par rapport au silicium. La couche 210 protège les flancs de la grille 130 du transistor de commande lors de cette étape. La largeur des flancs situés de part et d'autre de la grille 130 du transistor de commande est donc préservée par la couche 210.

Les deux figures suivantes illustrent les opérations de gravure de la grille de contrôle du transistor de mémorisation dans la couche résiduelle 210 de silicium polycristallin. La gravure se fait en deux étapes :
- Le résultat de la première étape de gravure est illustré par la **figure 2g****.** On emploie une gravure très anisotrope de type RIE, acronyme de l'anglais « reactive ion etching », c'est-à-dire « gravure ionique réactive ». Il s'agit d'une gravure sèche qui est couramment pratiquée par l'industrie de la microélectronique. Elle se pratique dans une chambre de confinement à basse pression où l'on forme un plasma à partir de champs électriques et/ou magnétiques. Le plasma réagit physiquement et chimiquement principalement avec les surfaces horizontales de la tranche qui sont bombardées par les ions à haute énergie du plasma. Cette première étape de gravure permet de préserver au mieux la planéité de la surface de silicium polycristallin 218 au dessus de l'empilement de couches des grilles de commande, tout en diminuant l'épaisseur de la couche 210 de silicium polycristallin en dehors de ces zones. À l'issue de cette première étape de gravure anisotrope, il reste à enlever une épaisseur résiduelle 219 entre les zones de grilles de commande. On ne laisse de préférence qu'une mince épaisseur 217 de l'ordre de 5 à 10 nm de la couche 210 au dessus des grilles de commande. L'arrêt de cette gravure se fait au temps.
- Le résultat de la seconde étape de gravure du silicium polycristallin qui va servir à former la grille de contrôle du transistor de mémorisation est montré sur la **figure 2h****.** Cette étape de gravure est plutôt isotrope et affecte donc toutes les surfaces quelles que soient leur orientation. De ce fait elle contribuera également à arrondir les angles. De plus, elle est sélective par rapport à l'oxyde de silicium qui constitue la couche supérieure 1433 d'isolant de l'empilement 143 de couches ONO décrit précédemment. C'est cette couche 1433 qui constitue donc la couche d'arrêt de cette seconde étape de gravure. Cette étape de gravure permet d'obtenir les motifs 142 destinés à former la grille de contrôle du transistor de mémorisation et présentant une surface plane 145 importante permettant une reprise de contact aisée sur cette grille. La seconde étape de gravure repose sur l'emploi de solutions d'attaque chimique à base de chlore (Cl₂) et de fluor (F).

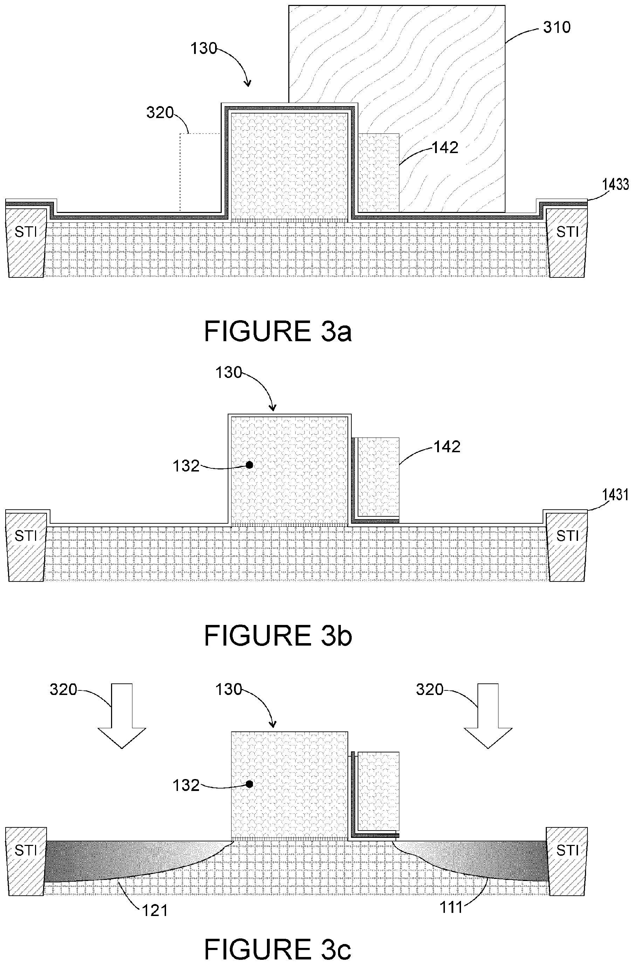

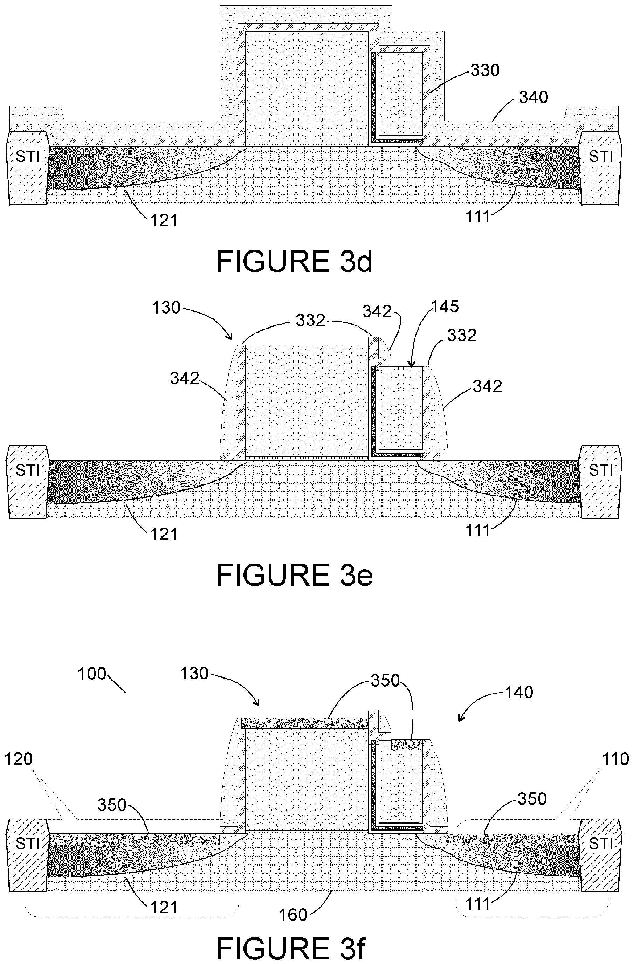

La **figure 3****,** qui comprend les figures 3a à 3f, décrit les étapes suivantes du procédé de formation de la grille de contrôle du transistor de mémorisation. Ces étapes permettent de finaliser la structure de la cellule mémoire présentant une surface de reprise de contact beaucoup plus large en raison de l'application préalable des étapes décrites en référence aux figures précédentes.

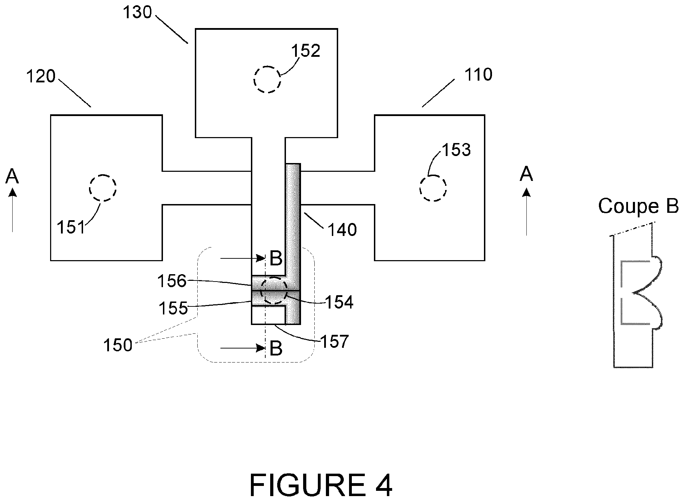

La **figure 3a** décrit l'étape où on délimite la zone de la grille de contrôle 140 du transistor de mémorisation qui va être gardée. Comme illustré sur la figure 4 qui sera décrite en détail par la suite, cette figure étant est une vue en plan d'un exemple non limitatif de cellule mémoire, on ne laisse subsister par photogravure qu'une partie du motif 142 que l'on vient de créer à partir de la couche 210 de silicium polycristallin, comme expliqué dans les figures 2a à 2h, et qui constitue l'espaceur de la grille du transistor de commande. Cet espaceur a été créé sans lithographie tout autour de la grille du transistor de commande et on ne le laisse subsister que sur un des flancs pour y former la grille de contrôle 140 du transistor de mémorisation. Optionnellement, on peut créer une zone de reprise 150 plus large, par exemple dans le prolongement de la grille 130 du transistor de commande comme illustré et décrit en référence à la figure 4. La figure 3a montre, en coupe, la couche de résine photosensible utilisée par l'opération de photolithographie correspondante après révélation des motifs de résine 310 qui vont protéger la partie de l'espaceur constitué du motif 142 qui doit rester en place.

A ce stade on procède, dans les zones non protégées 320 par la résine, à une gravure des motifs issus de la couche 210 de silicium polycristallin destinée à former la grille de contrôle 140 du transistor de mémorisation. Cette gravure peut être une gravure sèche, très sélective par rapport au SiO₂. L'arrêt de la gravure se fait comme précédemment sur la couche supérieure 1433 de l'empilement 143 de couches ONO, c'est-à-dire sur la couche d'oxyde 1433 dans cet exemple.

La **figure 3b** illustre l'étape où, après enlèvement de la résine, on procède à une gravure sèche des deux couches supérieures de l'empilement de couches 143 ONO. On grave alors successivement la couche supérieure d'isolant 1433 (oxyde de silicium dans cet exemple), puis la couche intermédiaire 1432 (nitrure de silicium dans cet exemple). La gravure se fait sur toute la surface des dispositifs en cours de fabrication. Le sandwich 143 de couches ONO est protégé de l'attaque dans la grille de contrôle du transistor de mémorisation par le motif 142 de silicium polycristallin. La figure 3b est une vue en coupe à l'issue de cette gravure. Il ne reste donc en place à ce stade que la couche inférieure d'isolant 1431 (oxyde de silicium dans cet exemple) de la couche ONO qui sert d'arrêt à la gravure ci-dessus

La figure 3c illustre l'étape de dopage des zones source 121 et drain 111. Ce dopage est effectué par implantation ionique 320 à travers la couche inférieure d'isolant 1431 restant de la couche ONO qui sert de protection au silicium sous jacent pour cette opération. Comme représenté, cette couche est ensuite enlevée par exemple en gravure humide.

Les **figures 3d** et **3e** illustrent la réalisation des espaceurs à partir des motifs 142 formés dans la couche 210, c'est-à-dire en silicium polycristallin dans cet exemple non limitatif.

On procède ensuite au dépôt d'une couche 330. Selon un exemple avantageux, cette couche est un oxyde dit HTO, de l'anglais « high temperature oxide », c'est-à-dire « oxyde à haute température » obtenu par la technique LPCVD déjà mentionnée précédemment, à une température par exemple de 730°C. Typiquement, une épaisseur de 10 nm est déposée. En tout état de cause cette épaisseur doit être suffisante pour combler les vides résultant de la gravure isotrope des couches d'oxyde de l'empilement 143 de couches ONO intervenue précédemment. Cette couche permet aussi d'obtenir une bonne adhérence pour le dépôt de la couche suivante 340, décrite ci-après. Par ailleurs elle va servir de couche d'arrêt à la gravure.

Comme montré sur la figure 3d, le dépôt de la couche 330 est suivi d'un dépôt d'une couche 340, par exemple de nitrure de silicium (Si₃N₄). Ce dépôt peut être réalisé par la même technique que ci-dessus de dépôt chimique en phase vapeur à basse pression (LPCVD). On dépose une couche de nitrure de silicium qui est typiquement comprise dans une gamme d'épaisseur allant de 20 à 40 nm. Cette couche va servir à former les espaceurs 342 qui permettent d'éloigner des grilles de sélection et de mémorisation les implantations ioniques auto alignées des électrodes source et drain et la siliciuration des contacts qui suivent.

La **figure 3e** montre le résultat de la gravure des couches ci-dessus, c'est-à-dire : la couche 340 de Si₃N₄ puis la couche 330 de HTO. D'une façon conventionnelle, la gravure de ces couches est dans un premier temps très anisotrope afin de laisser en place sur les flancs des grilles de commande et de mémorisation les motifs 332, en HTO, et les motifs 342 en Si3N4 qui servent d'espaceurs de grilles. Cette gravure très anisotrope est suivie d'une gravure plus isotrope afin d'être sélectif et permettre l'arrêt de la gravure sur le silicium polycristallin des grilles de commande et de mémorisation. Cette seconde gravure doit être suffisante pour dégager le haut 145 du motif 146 servant de reprise de contact sur la grille de contrôle du transistor de mémorisation et le haut de la grille du transistor de commande qui vont être siliciurés pour assurer un bon contact électrique.

Typiquement, à ce stade, on procède aussi à une seconde implantation des électrodes de source 111 et drain 121 afin d'en diminuer la résistance électrique. Cette seconde implantation est auto limitée par les espaceurs de grilles que l'on vient de réaliser.

La **figure 3f** montre les zones 350 qui sont ensuite siliciurées afin d'obtenir un meilleur contact électrique avec les vias, qui donnent accès aux électrodes de la cellule mémoire à double grille : grille 130 du transistor de commande et grille de contrôle 140 du transistor de mémorisation. Des exemples de tels vias sont illustrés en figures 4. Comme la seconde implantation ci-dessus, la siliciuration des contacts est auto limitée par les espaceurs de grilles.

Un avantage supplémentaire de la présente invention réside dans le fait que le volume de matériau semi conducteur accessible pour effectuer l'étape de siliciuration est augmenté par rapport aux procédés connus. Le volume de zones siliciurés est donc augmenté et le contact électrique est amélioré.

Cette opération complète la formation des électrodes et éléments actifs des cellules mémoires non volatiles à double grille 100 pouvant bénéficier du procédé de l'invention. Les opérations suivantes concernent la formation de toutes les interconnexions entre les composants et cellules mémoire d'un dispositif, celles dites de « fin de ligne » ou BEOL de l'anglais « back end of line », qui peuvent être effectuées d'une façon standard en particulier parce que la reprise de contact sur la grille mémoire ou à l'arrière de la grille mémoire (sur une zone encore élargie) est beaucoup plus large ce qui ne demande pas de pouvoir positionner les vias correspondants avec une plus grande précision.

La **figure 4** illustre une vue en plan d'un exemple particulier et non limitatif de l'invention d'une cellule mémoire à double grille. Cette vue en plan montre les quatre électrodes contrôlant le point mémoire. On notera ici que les figures 1a et 1b sont des vues selon la coupe A de la cellule mémoire à une échelle toutefois différente. Cette vue fait apparaître notamment la source 110, le drain 120 et la grille 130 du transistor de commande. La source 110, le drain 120 et la grille 130 du transistor de commande sont formés par lithographie. On peut ménager, comme représenté, de larges surfaces de connexion destinées à recevoir des connexions verticales, c'est à dire les vias 151, 152 et 153, qui assurent les interconnexion avec les couches de câblage horizontales (non représentées) du dispositif contenant de telles cellules mémoires. La cellule comprend également une grille de contrôle 140 du transistor de mémorisation. La grille de contrôle 140 du transistor de mémorisation est formée, sans avoir recours à la lithographie, comme un espaceur sur un des flancs de la grille 130 du transistor de commande. La surface de connexion est comme déjà vu ci-dessus beaucoup plus réduite. Une amélioration apportée par cette structure particulière de cellule mémoire par rapport aux structures conventionnelles consiste à sensiblement doubler cette surface de contact en créant une zone 150 de reprise de contact électrique située, dans cet exemple, dans le prolongement de la grille 130 du transistor de commande. On s'arrange alors pour laisser dans cette zone, entre l'extrémité de la grille 130 du transistor de commande et un motif ou bloc 157 séparé, préférentiellement de même largeur et de même composition que la grille 130 du transistor de commande, deux espaceurs à une distance telle qu'ils seront en contact comme schématisé sur la coupe B. C'est dans cette région qu'un via 154 pourra assurer un contact électrique avec la grille 130 du transistor de commande. En pratique, une telle zone de reprise de contact n'est pleinement utile que si l'on sait obtenir en même temps une forme arrondie ou plane de l'espaceur comme dans l'exemple de la figure 1b.

De manière générale la cellule mémoire dont un exemple particulier est représenté en figure 4 peut présenter les caractéristiques suivantes. Elle comprend au moins :
- une zone active formée dans une couche de semi-conducteur et comportant un canal disposé entre une source 110 et un drain 120,
- une première grille disposée au moins sur une première partie du canal,
- au moins une portion 155 d'un premier espaceur latéral disposé contre au moins un flanc latéral de la première grille, dont une partie forme une seconde grille disposée sur au moins une seconde partie du canal. L'une de la première ou de la seconde grille comportant en outre un empilement de couches 143 dont au moins une desdites couches est apte à stocker des charges électriques. De préférence, la première grille forme la grille 130 du transistor de commande et la seconde grille forme la grille de contrôle 140 du transistor de mémorisation.

De préférence, la cellule mémoire comporte en outre au moins une portion d'un deuxième espaceur latéral disposé contre au moins un flanc latéral d'un bloc 157 disposé sur la couche de semi-conducteur, le deuxième espaceur latéral étant en contact avec le premier espaceur latéral, le premier le second espaceur latéral étant composés de matériaux similaires, ladite portion du second espaceur latéral formant au moins une partie d'un plot de contact

De manière optionnelle, dans cet exemple, une portion 156 est reliée électriquement à la seconde grille. Cette portion 156 est disposée contre deux flancs latéraux de la première grille distincts et perpendiculaires l'un par rapport à l'autre. Le plot de contact électrique, ou surface de reprise de contact, est ici formé par cette portion d'espaceur 156 et la portion d'espaceur 155 formée contre le bloc 157, et est disposé dans le prolongement de la première grille. Une telle variante de réalisation a notamment pour avantage de pouvoir rapprocher les lignes électriquement conductrices destinées à être réalisées pour contacter la première grille et la seconde grille, permettant ainsi d'augmenter la densité d'un dispositif mémoire formé d'une matrice de cellules mémoires.

Cette structure de cellule mémoire électronique à double grille permet de réaliser une reprise de contact électrique de chacune de grille avec un risque de court-circuit réduit entre les grilles. Cette structure permet de relâcher quelque peu les contraintes liées à l'alignement des contacts électriques par rapport aux grilles de la cellule mémoire, et cela sans avoir à mettre en oeuvre un niveau de photolithographie supplémentaire dédié à cette reprise de contact électrique.

Cependant il s'est avéré qu'en pratique, la reprise de contact pour ce type de cellule n'est réellement facilitée et les risques de courts circuits significativement réduits que si l'on parvient à obtenir une forme arrondie ou sensiblement plane de l'espaceur comme dans l'exemple de la figure 1b.

Le procédé selon l'invention et dont un exemple particulier est décrit en référence aux figures 2a à 3f permet d'obtenir ce type de forme. L'invention permet donc de faciliter considérablement la reprise de contact et ceci pour des structures variées de cellules mémoire, la structure décrite ci-dessus et dont un exemple est illustré en figure 4 n'étant pas limitative de l'invention. Le procédé selon la présente invention, appliqué à une cellule mémoire présentant une structure telle que décrite aux paragraphes faisant référence à la figure 4, permet d'atteindre des résultats particulièrement avantageux.

L'invention n'est pas limitée aux seuls exemples de réalisation précédemment décrits et s'étend à tous les modes de réalisation entrant dans la portée des revendications.

Notamment, l'invention ne se limite pas à une couche 210 de silicium polycristallin. Cette couche pourra également être constituée de tout autre matériau semi-conducteur ou d'un empilement de couches comprenant un matériau semi-conducteur. De même, l'invention ne se limite pas à une couche 220 en SiO2. Cette couche pourra également être constituée de tout autre matériau facile à déposer, pouvant être aplani par une méthode de type CMP (polissage mécano-chimique) et pouvant être enlevé par une solution chimique.

Au vu de la description qui précède, il apparaît ainsi clairement que la présente invention permet l'obtention d'un cellule mémoire électronique à double grille permettant de réaliser une reprise de contact électrique de chacune des grilles ne nécessitant pas un alignement ultra précis des contacts électriques par rapport aux grilles et en limitant le risque de court-circuit entre ces dernières.

## Revendications

1. Procédé de fabrication d'une cellule mémoire non volatile à double grille (100) comprenant un transistor de commande comprenant une grille (130) et un transistor de mémorisation comprenant une grille de contrôle (140) adjacente à la grille (130) du transistor de commande, dans lequel on effectue les étapes de:
∘ formation au moins partielle de la grille (130) du transistor de commande comprenant notamment l'obtention d'un relief (132) en un matériau semi conducteur sur un substrat (160, 162);
∘ formation de la grille de contrôle (140) du transistor de mémorisation, comprenant une étape de dépôt d'une couche (210) en un matériau semi conducteur de manière à recouvrir au moins le relief (132) de la grille (130) du transistor de commande;
la formation de la grille de contrôle (140) du transistor de mémorisation comprenant en outre les étapes suivantes:
∘ dépôt sur la couche (210) en un matériau semi conducteur d'une autre couche (220) d'une épaisseur (221) telle que la face supérieure de ladite autre couche (220) est en tout point située au dessus du relief (132) de la grille (130) du transistor de commande ;
∘ retrait de ladite autre couche (220) de part et d'autre du relief (132) de la grille (130) du transistor de commande,
∘ gravure de la couche (210) en un matériau semi conducteur de sorte à retirer ce matériau au dessus du relief (132) de la grille (130) du transistor de commande et à ne le laisser subsister qu'un motif (142) sur au moins un flanc du relief (132) de la grille (130) du transistor de commande
**caractérisé en ce que** la formation de la grille de contrôle (140) du transistor de mémorisation comprend en outre l'étape suivante effectuée entre ladite étape de dépôt de ladite autre couche (220) et ladite étape de retrait: polissage mécano chimique (CMP) effectué de manière à retirer, au-dessus du relief (132) de la grille (130) du transistor de commande, ladite autre couche (220) et une partie de la couche (210) en un matériau semi-conducteur.

2. Procédé selon la revendication précédente dans lequel l'étape de polissage mécano chimique comprend une première étape de polissage mécano chimique effectuée de manière à rendre sensiblement plane la surface (227) de ladite autre couche (220).

3. Procédé selon la revendication précédente dans lequel l'étape de polissage mécano chimique comprend une deuxième étape de polissage mécano chimique effectuée de manière à réduire l'épaisseur (215) de la couche (210) en un matériau semi conducteur située au dessus du relief (132) de la grille (130) du transistor de commande.

4. Procédé selon l'une quelconque des revendications précédentes dans lequel l'étape de polissage mécano chimique est effectuée de sorte à retirer environ 20% de l'épaisseur de la couche (210) en un matériau semi conducteur.

5. Procédé selon l'une quelconque des revendications précédentes dans lequel l'étape de gravure comprend notamment une gravure anisotrope de la couche (210) en un matériau semi-conducteur, l'étape de gravure anisotrope étant de préférence effectuée de sorte à préserver, au dessus du relief (132) de la grille (130) du transistor de commande, une épaisseur (217) de la couche (210) en un matériau semi conducteur comprise entre 5 nm et 10 nm.

6. Procédé selon la revendication 5 dans lequel l'étape de gravure comprend, après la gravure anisotrope, une gravure isotrope de la couche (210) en un matériau semi conducteur restant avec arrêt de la gravure sur une couche supérieure d'oxyde (1433) et dans lequel la couche supérieure d'oxyde (1433) est disposée sur le relief (132) de la grille (130) du transistor de commande préalablement au dépôt de la couche (210) en un matériau semi conducteur.

7. Procédé selon l'une quelconque des revendications précédentes dans lequel l'étape de dépôt de la couche (210) en un matériau semi conducteur est effectuée de sorte que l'épaisseur de la couche (210) en un matériau semi conducteur telle que déposée est comprise entre 0.2 et 0.8 fois l'épaisseur du relief (132) de la grille (130) du transistor de commande, de manière préférée l'épaisseur de la couche (210) en un matériau semi-conducteur étant sensiblement égale à la moitié de l'épaisseur de silicium du relief (132) de la grille (130) du transistor de commande, et de manière encore plus préférentielle, l'épaisseur de la couche (210) en un matériau semi-conducteur étant inférieure à l'épaisseur de ladite autre couche (220).

8. Procédé selon l'une quelconque des revendications précédentes dans lequel l'étape de dépôt de la couche (210) en un matériau semi conducteur est effectuée de manière à ce que l'épaisseur de la couche (210) en un matériau semi conducteur soit sensiblement constante.

9. Procédé selon l'une quelconque des revendications précédentes dans lequel l'étape de dépôt de ladite autre couche (220) est effectuée de sorte que son épaisseur est supérieure à 1.1 fois et de préférence supérieure à 1.3 fois l'épaisseur du relief (132) de la grille (130) du transistor de commande.

10. Procédé selon l'une quelconque des revendications précédentes dans lequel le relief (132) de la grille (130) du transistor de commande est en silicium polycristallin.

11. Procédé selon la revendication précédente dans lequel la couche (210) en un matériau semi conducteur est en silicium polycristallin et, de préférence, dans lequel ladite autre couche (220) est en dioxyde de silicium (SiO₂).

12. Procédé selon l'une quelconque des revendications précédentes dans lequel la grille de contrôle (140) du transistor de mémorisation forme un espaceur pour la grille (130) du transistor de commande.

13. Procédé selon l'une quelconque des revendications précédentes dans lequel la formation de la grille de contrôle (140) du transistor de mémorisation est effectuée de sorte que la grille de contrôle (140) du transistor de mémorisation est auto alignée avec la grille (130) du transistor de commande.

14. Procédé selon l'une quelconque des revendications précédentes comprenant, préalablement à l'étape de dépôt de la couche (210) en un matériau semi conducteur, une étape de formation d'un empilement de couches (143) sur au moins un flanc du relief (132) de la grille (130) du transistor de commande et au moins une partie du substrat (160, 162), l'empilement de couches (143) étant configuré pour stocker des charges électriques.

15. Procédé selon l'une quelconque des revendications précédentes comprenant une étape de siliciuration d'une surface (145) supérieure du motif (142).

## Patentansprüche

1. Verfahren zur Herstellung einer nicht flüchtigen Speicherzelle mit Dualgate (100), umfassend einen Steuertransistor, der ein Gate (130) umfasst, und einen Speichertransistor, der ein Steuergate (140) umfasst, welches an das Gate (130) des Steuertransistors angrenzt, wobei die Schritte vorgenommen werden des:
∘ mindestens teilweisen Bildens des Gates (130) des Steuertransistors, das vor allem das Erhalten einer Erhebung (132) aus einem Halbleitermaterial auf einem Substrat (160, 162) umfasst;
∘ Bildens des Steuergates (140) des Speichertransistors, das einen Schritt des Abscheidens einer Schicht (210) aus einem Halbleitermaterial umfasst, um mindestens die Erhebung (132) des Gates (130) des Steuertransistors zu bedecken;
wobei das Bilden des Steuergates (140) des Speichertransistors weiter die folgenden Schritte umfasst:
∘ Abscheiden einer weiteren Schicht (220) mit einer solchen Dicke (221) auf der Schicht (210) aus einem Halbleitermaterial, dass die obere Seite der weiteren Schicht (220) an jedem Punkt über der Erhebung (132) des Gates (130) des Steuertransistors liegt;
∘ Entfernen der weiteren Schicht (220) auf beiden Seiten der Erhebung (132) des Gates (130) des Steuertransistors,
∘ Ätzen der Schicht (210) aus einem Halbleitermaterial derart, dass dieses Material über der Erhebung (132) des Gates (130) des Steuertransistors entfernt wird und dass es nur als ein Muster (142) an mindestens einer Flanke der Erhebung (132) des Gates (130) des Steuertransistors belassen wird,
**dadurch gekennzeichnet, dass** das Bilden des Steuergates (140) des Speichertransistors weiter den folgenden Schritt umfasst, der zwischen dem Schritt des Abscheidens der weiteren Schicht (220) und dem Schritt des Entfernens vorgenommen wird: chemisch-mechanisches Polieren (CMP), das vorgenommen wird, um die weitere Schicht (220) und einen Teil der Schicht (210) aus einem Halbleitermaterial über der Erhebung (132) des Gates (130) des Steuertransistors zu entfernen.

2. Verfahren nach dem vorstehenden Anspruch, wobei der Schritt des chemisch-mechanischen Polierens einen ersten Schritt des chemisch-mechanischen Polierens umfasst, der vorgenommen wird, um die Oberfläche (227) der weiteren Schicht (220) im Wesentlichen eben zu machen.

3. Verfahren nach dem vorstehenden Anspruch, wobei der Schritt des chemisch-mechanischen Polierens einen zweiten Schritt des chemisch-mechanischen Polierens umfasst, der vorgenommen wird, um die Dicke (215) der Schicht (210) aus einem Halbleitermaterial, die über der Erhebung (132) des Gates (130) des Steuertransistors liegt, zu reduzieren.

4. Verfahren nach einem der vorstehenden Ansprüche, wobei der Schritt des chemisch-mechanischen Polierens derart vorgenommen wird, dass etwa 20 % der Dicke der Schicht (210) aus einem Halbleitermaterial entfernt werden.

5. Verfahren nach einem der vorstehenden Ansprüche, wobei der Schritt des Ätzens vor allem ein anisotropes Ätzen der Schicht (210) aus einem Halbleitermaterial umfasst, wobei der Schritt des anisotropen Ätzens vorzugsweise derart vorgenommen wird, dass über der Erhebung (132) des Gates (130) des Steuertransistors eine Dicke (217) der Schicht (210) aus einem Halbleitermaterial im Bereich zwischen 5 nm und 10 nm beibehalten wird.

6. Verfahren nach Anspruch 5, wobei der Schritt des Ätzens nach dem anisotropen Ätzen ein isotropes Ätzen der restlichen Schicht (210) aus einem Halbleitermaterial mit Stoppen des Ätzens an einer oberen Oxidschicht (1433) umfasst, und wobei die obere Oxidschicht (1433) vor dem Abscheiden der Schicht (210) aus einem Halbleitermaterial auf der Erhebung (132) des Gates (130) des Steuertransistors angeordnet wird.

7. Verfahren nach einem der vorstehenden Ansprüche, wobei der Schritt des Abscheidens der Schicht (210) aus einem Halbleitermaterial derart vorgenommen wird, dass die Dicke der Schicht (210) aus einem Halbleitermaterial so wie abgeschieden im Bereich zwischen dem 0,2- und 0,8-fachen der Dicke der Erhebung (132) des Gates (130) des Steuertransistors beträgt, wobei die Dicke der Schicht (210) aus einem Halbleitermaterial vorzugsweise im Wesentlichen gleich der Hälfte der Siliziumdicke der Erhebung (132) des Gates (130) des Steuertransistors ist, und wobei die Dicke der Schicht (210) aus einem Halbleitermaterial noch stärker bevorzugt kleiner ist als die Dicke der weiteren Schicht (220).

8. Verfahren nach einem der vorstehenden Ansprüche, wobei der Schritt des Abscheidens der Schicht (210) aus einem Halbleitermaterial so vorgenommen wird, dass die Dicke der Schicht (210) aus einem Halbleitermaterial im Wesentlichen konstant ist.

9. Verfahren nach einem der vorstehenden Ansprüche, wobei der Schritt des Abscheidens der weiteren Schicht (220) derart vorgenommen wird, dass ihre Dicke mehr als das 1,1-fache, und vorzugsweise mehr als das 1,3-fache der Dicke der Erhebung (132) des Gates (130) des Steuertransistors beträgt.

10. Verfahren nach einem der vorstehenden Ansprüche, wobei die Erhebung (132) des Gates (130) des Steuertransistors aus polykristallinem Silizium ist.

11. Verfahren nach dem vorstehenden Anspruch, wobei die Schicht (210) aus einem Halbleitermaterial aus polykristallinem Silizium ist, und wobei die weitere Schicht (220) vorzugsweise aus Siliziumdioxid (SiO₂) ist.

12. Verfahren nach einem der vorstehenden Ansprüche, wobei das Steuergate (140) des Speichertransistors einen Abstandshalter für das Gate (130) des Steuertransistors bildet.

13. Verfahren nach einem der vorstehenden Ansprüche, wobei das Bilden des Steuergates (140) des Speichertransistors derart vorgenommen wird, dass das Steuergate (140) des Speichertransistors selbständig zum Gate (130) des Steuertransistors ausgerichtet wird.

14. Verfahren nach einem der vorstehenden Ansprüche, das vor dem Schritt des Abscheidens der Schicht (210) aus einem Halbleitermaterial einen Schritt des Bildens eines Schichtenstapels (143) an mindestens einer Flanke der Erhebung (132) des Gates (130) des Steuertransistors und mindestens einem Teil des Substrats (160, 162) umfasst, wobei der Schichtenstapel (143) dafür konfiguriert ist, elektrische Ladungen zu speichern.

15. Verfahren nach einem der vorstehenden Ansprüche, das einen Schritt des Silizierens einer oberen Oberfläche (145) des Musters (142) umfasst.

## Claims

1. Method for producing a double-gate non-volatile memory cell (100) comprising a driver transistor comprising a gate (130) and a memory transistor comprising a control gate (140) adjacent to the gate (130) of the driver transistor, wherein the following steps are carried out:
∘ forming at least partially the gate (130) of the driver transistor comprising the obtaining of a relief (132) made of a semi-conductive material on a substrate (160, 162);
∘ forming the control gate (140) of the memory transistor, comprising steps of depositing a layer (210) made of a semi-conductive material so as to cover at least the relief (132) of the gate (130) of the driver transistor;
the formation of the control gate (140) of the memory transistor further comprising the following steps:
∘ depositing on the layer (210) made of a semi-conductive material of another layer (220) of a thickness (221) such that the upper face of said other layer (220) is in any point located above the relief (132) of the gate (130) of the driver transistor;
∘ removing said other layer (220) on either side of the relief (132) of the gate (130) of the driver transistor;
∘ etching of the layer (210) made of a semi-conductive material so as to remove this material above the relief (132) of the gate (130) of the driver transistor and to only letting one pattern (142) subsist on at least one side of the relief (132) of the gate (130) of the driver transistor
**characterised in that** the formation of the control gate (140) of the memory transistor further comprises the following step carried out between said step of depositing said other layer (220) and said removal step: chemical mechanical polishing (CMP) carried out so as to remove, above the relief (132) of the gate (130) of the driver transistor, said other layer (220) and a portion of the layer (210) made of a semi-conductive material.

2. Method according to the preceding claim, wherein the chemical mechanical polishing step comprises a first chemical mechanical polishing step carried out so as to make the surface (227) of said other layer (220) substantially flat.

3. Method according to the preceding claim, wherein the chemical mechanical polishing step comprises a second chemical mechanical polishing step carried out so as to reduce the thickness (215) of the layer (210) made of a semi-conductive material located above the relief (132) of the gate (130) of the driver transistor.

4. Method according to any one of the preceding claims, wherein the chemical mechanical polishing step is carried out so as to remove around 20% of the thickness of the layer (210) made of a semi-conductive material.

5. Method according to any one of the preceding claims, wherein the etching step comprises, in particular, an anisotropic etching of the layer (210) made of a semi-conductive material, the anisotropic etching step preferably being carried out so as to preserve, above the relief (132) of the gate (130) of the driver transistor, a thickness (217) of the layer (210) made of a semi-conductive material of between 5nm and 10nm.

6. Method according to claim 5, wherein the etching step comprises, after the anisotropic etching, an isotropic etching of the layer (210) made of a semi-conductive material remaining with stopping the etching on an upper oxide layer (1433) and wherein the upper oxide layer (1433) is arranged on the relief (132) of the gate (130) of the driver transistor prior to the deposition of the layer (210) made of a semi-conductive material.

7. Method according to any one of the preceding claims, wherein the step of depositing a layer (210) made of a semi-conductive material is carried out such that the thickness of the layer (210) made of a semi-conductive material such as deposited is of between 0.2 and 0.8 times the thickness of the relief (132) of the gate (130) of the driver transistor, preferably the thickness of the layer (210) made of a semi-conductive material being substantially equal to half the silicon thickness of the relief (132) of the gate (130) of the driver transistor, and even more preferably, the thickness of the layer (210) made of a semi-conductive material being less than the thickness of said other layer (220).

8. Method according to any one of the preceding claims, wherein the step of depositing the layer (210) made of a semi-conductive material is carried out such that the thickness of the layer (210) made of a semi-conductive material is substantially constant.

9. Method according to any one of the preceding claims, wherein the step of depositing said other layer (220) is carried out such that the thickness thereof is greater than 1.1 times and preferably greater than 1.3 times the thickness of the relief (132) of the gate (130) of the driver transistor.

10. Method according to any one of the preceding claims, wherein the relief (132) of the gate (130) of the driver transistor is made of polycrystalline silicon.

11. Method according to the preceding claim, wherein the layer (210) made of a semi-conductive material is made of polycrystalline silicon and, preferably, wherein said other layer (220) is made of silicon oxide (SiO₂).

12. Method according to any one of the preceding claims, wherein the control gate (140) of the memory transistor forms a spacer for the gate (130) of the driver transistor.

13. Method according to any one of the preceding claims, wherein the formation of the control gate (140) of the memory transistor is carried out such that the control gate (140) of the memory transistor is self-aligned with the gate (130) of the driver transistor.

14. Method according to any one of the preceding claims comprising, prior to the step of depositing the layer (210) made of a semi-conductive material, a step of forming a stack of layers (143) on at least one edge of the relief (132) of the gate (130) of the driver transistor and at least one portion of the substrate (160, 162), the stack of layers (143) being configured to store electrical charges.

15. Method according to any one of the preceding claims comprising a step of silicifying an upper surface (145) of the pattern (142).
